Europäisches Patentamt

European Patent Office

Office européen des brevets

(11) Publication number: **0 412 772 A2**

# EUROPEAN PATENT APPLICATION

(21) Application number: **90308672.6**

(51) Int. Cl.5: **H01L 23/31**

(22) Date of filing: **07.08.90**

(30) Priority: **09.08.89 JP 207223/89**

(43) Date of publication of application:
**13.02.91 Bulletin 91/07**

(84) Designated Contracting States:
**DE FR GB**

(71) Applicant: **SEIKO INSTRUMENTS INC.**
**31-1, Kameido 6-chome Koto-ku**
**Tokyo 136(JP)**

(72) Inventor: **Imura, Yukihiro**
**c/o Seiko Instruments Inc., 31-1 Kameido**
**6-chome**
**Koto-ku, Tokyo(JP)**

(74) Representative: **Caro, William Egerton et al**
**J. MILLER & CO. Lincoln House 296-302 High**
**Holborn**
**London WC1V 7JH(GB)**

(54) **Semi-conductor device.**

(57) The invention provides a semi-conductor device having as a passivation layer covering a metal wire (4) of a MOS transistor and a semi-conductor surface a double layer comprising a silicon nitride layer (7) and a silicide glass layer (5) beneath the silicon nitride layer. A window (8) is provided through the silicon nitride layer at a location away from a gate electrode (9) of the MOS transistor. Advantageously, the edge of the window lies between 20 μm and 100 μm from an edge of the gate electrode.

# FIG.1

Xerox Copy Centre

## SEMI-CONDUCTOR DEVICE

The present invention relates to a semi-conductor device.

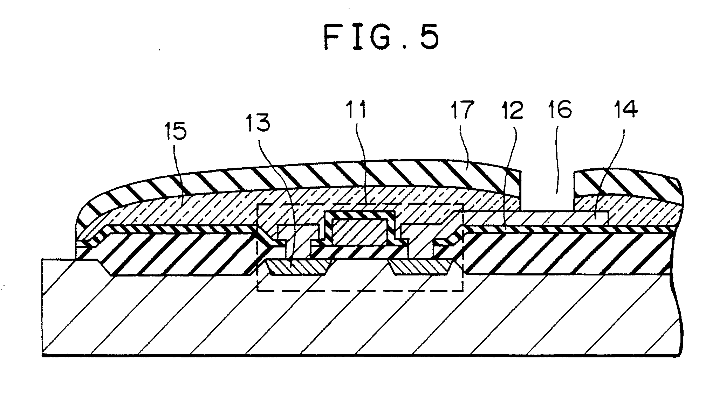

Figure 5 shows a structural cross sectional view of a semi-conductor device having a conventional passivation layer. After an interlayer dielectric layer 12 is accumulated on a transistor 11 and a contact hole 13 is provided at a desired position of the transistor through the interlayer dielectric layer and a gate oxide layer of the transistor, a metal wire 14 is fabricated. A phosphorous silicide glass (PSG) layer 15 is then accumulated and is removed at a pad portion 16 for providing contact with the exterior. After that, a P-SiN layer 17 is accumulated and is removed at the pad portion 16.

The double layer, composed of the PSG layer 15 and the P-SiN layer 17 as described above, has been used in many semi-conductor integrated circuits. Reasons for using the double layer composed of the PSG layer 15 and the P-SiN layer 17 are as follows: (1) The thick PSG layer (0.5 $\mu$m to 2 $\mu$m) protects the semi-conductor surface from contamination by alkaline metals and damage caused by foreign substances. (2) The P-SiN layer protects the semi-conductor integrated circuit from the penetration of moisture.

The P-SiN layer 17 is well known as a passivation layer for semi-conductor integrated circuits on account of the wetproof nature thereof. However, it has recently been found that the presence of P-SiN accelerates the deterioration of a MOS transistor in the semi-conductor integrated circuit caused by hot electrons. The more distinctive deterioration caused by the hot electrons results from blocking the diffusion of hydrogen out of the semi-conductor integrated circuit with the P-SiN layer, though the P-SiN layer is good for protecting the transistor from the penetration of moisture.

The hydrogen which is taken into the semi-conductor integrated circuit is produced in various processes during the manufacture of the semi-conductor integrated circuit. Especially, abundant hydrogen is produced when hydrogen annealing is performed, or when P-SiN is composed in a process employing a CVD method using a hydrogen compound. This hydrogen is thought to be a cause of production of a hot electron trap in the gate oxide layer.

Thus, if P-SiN is used as the passivation material, there remains the problem of forming the passivation layer such that a MOS transistor is protected from deterioration caused by hot electrons.

It is an object of the present invention to solve said problem by employing a double passivation layer formed by superposing a P-SiN layer on a PSG layer, and providing a vacant region (a window) in the P-SiN layer.

According to the present invention, there is provided a semi-conductor device having as a passivation layer, which covers a metal wire of a MOS transistor and a semi-conductor surface, a double layer comprising a silicon nitride layer and a silicide glass layer beneath the silicon nitride layer, characterised in that a window is provided through the silicon nitride layer at a location away from a gate electrode of said MOS transistor.

Preferably, the window is situated at a location more than 20 $\mu$m and less than 100 $\mu$m away from the edge of the gate of the MOS transistor.

Although the P-SiN layer is used as the passivation layer in the present invention, the hydrogen which is taken into the semi-conductor integrated circuit can be diffused to the outside easily by passing through the window, since the window in the P-SiN layer is positioned adjacent to the transistor.

Accordingly, although the P-SiN layer is used as the passivation layer in the present invention, deterioration of the MOS transistor caused by hot electrons does not increase, by comparison with a MOS transistor which uses only a PSG layer as the passivation layer, owing the presence of the window.

Further, the edge of the window is conveniently positioned more than 20 $\mu$m away laterally from the edge of the gate electrode in the MOS transistor. This is equivalent to the existence of the PSG layer with a thickness of 20 $\mu$m between the window and the transistor, and so the transistor is sufficiently wet-proofed.

The invention is described further, by way of example, with reference to the accompanying drawings, in which:-

Figure 1 is a cross sectional view of an embodiment of a semi-conductor device according to the present invention;

Figures 2a to 2g are cross sectional views of the semi-conductor device of Figure 1 at various stages during production;

Figure 3 is a graph demonstrating the relationship between change in threshold voltage, caused by a hot electron injection, and distance from the edge of a gate electrode to an edge of a window of the semi-conductor device;

Figure 4 is a graph demonstrating the relationship between change in threshold voltage, caused by hot electron injection, and a period of time for which the semi-conductor device is exposed to a high temperature and pressure in an aqueous vapour atmosphere; and

Figure 5 is a cross sectional view of a conventional semi-conductor device.

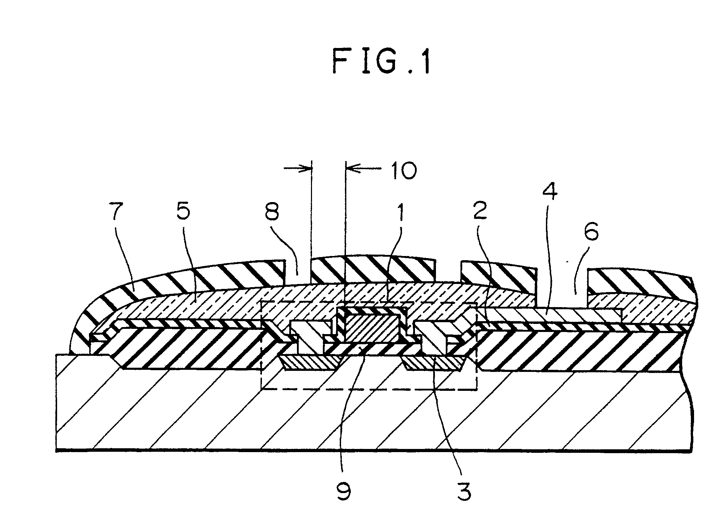

An embodiment of the present invention will be described with reference initially to Figure 1. The semi-conductor device shown in Figure 1 comprises an interlayer dielectric layer 2 superposed on a transistor 1, with a contact hole 3 provided at a desired position in the transistor 1 whereby the transistor 1 connects with a metal wire 4. A PSG layer 5 is removed, following its accumulation, at a pad portion 6 where the metal wire 4 extending from the contact hole 3 exists, in order to permit contact with the outside.

The production of the semi-conductor device shown in Figure 1 is completed after accumulating a P-SiN layer 7 on the PSG layer 5 and removing the P-SiN layer at the pad portion 6 and at a window 8. The distance 10 between the edge of the window 8 and the edge of a gate electrode 9 of the transistor 1 is not less than 20 $\mu$m and not more than 100 $\mu$m.

It is not always necessary to set up the window 8 for all the transistors of a device. It is effective to set up the window 8 on the peripheries of transistors in which hot electrons are inclined to be produced under bias conditions and of memory transistors which use hot electron channel injection.

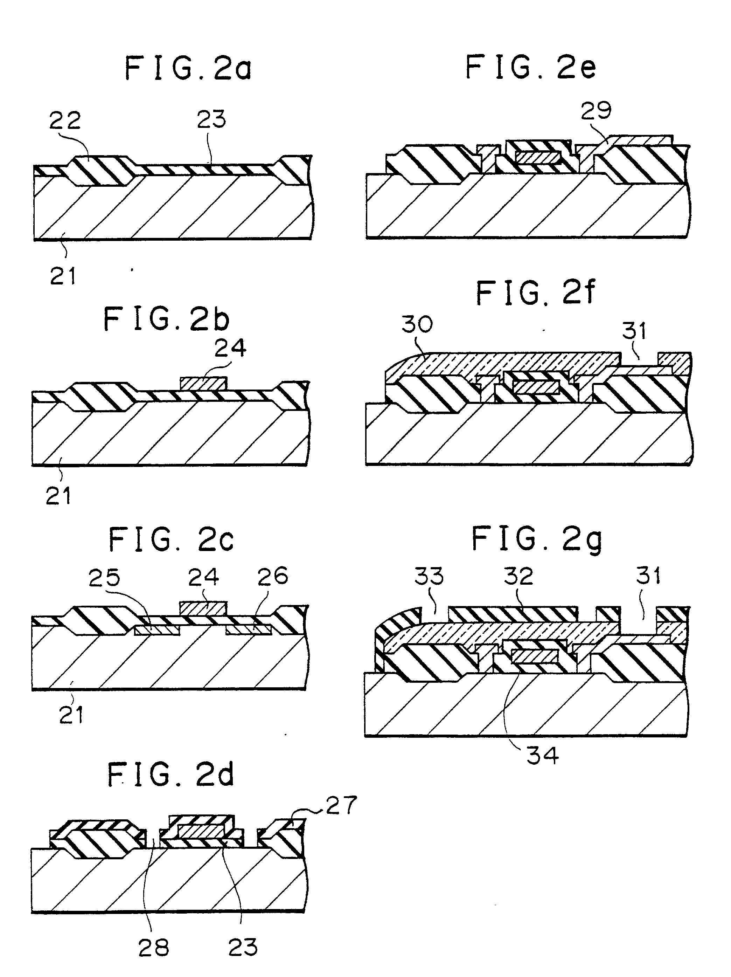

Next, the production method for such a semi-conductor device according to the present invention will be described with reference to the stages illustrated in Figures 2a to 2g.

Figure 2a shows a production process, which is generally called LOCOS.

That is, a field oxide layer 22 for device isolation and a gate oxide layer 23 are formed by oxidating the surface of a P type semi-conductor substrate 21.

A desired electrical conductivity is acquired by doping with an impurity, such as phosphorous, after the gate electrode 9 is formed by accumulating polysilicon and etching the polysilicon using photolysography (Figure 2b). A source region 25 and a drain region 26 are formed by doping the surface of the semi-conductor substrate 21 with impurity, such as phosphorous or arsenic, generally by means of ion implantation using the gate electrode 9 as a mask (Figure 2c).

The interlayer dielectric layer 2 is then formed by accumulating PSG by a CVD method on the whole surface of the field oxide layer 22 and the gate oxide layer 23 and the gate electrode 9. The contact hole 3 is formed by the removal of a part of the interlayer dielectric layer 2 and gate oxide layer 23 by etching using photolysography (Figure 2d).

The metal wire 4 is composed by accumulating a metal such as aluminium on the whole surface by vacuum evaporation or sputtering and then forming a desired pattern by photolysography (Figure 2e).

The pad opening 6 for connection of the metal wire 4 with an external wire is formed by etching after accumulating PSG to form the first passivation layer 5 (Figure 2f).

Lastly, the P-SiN which becomes the second protective layer 7 is accumulated by a plasma CVD method. The opening 6 is then provided through the P- SiN layer. The window 8 for diffusing hydrogen out of the semi-conductor device is also formed so that the edge of the window 8 is more than 20 $\mu$m and less than 100 $\mu$m away from the edge of the gate electrode 9. The opening 6 and the window 8 are both formed by etching (Figure 2g). The diameter of the wineow 8 is several $\mu$m to several tens of $\mu$m.

The present invention enables the contained hydrogen to diffuse effectively out of the integrated circuit and thereby prevents the transistor from deterioration caused by the hot electron trap. When the MOS transistor is annealed for several hours at 100$^\circ$C to 300$^\circ$C, this is effective to diffuse the hydrogen out promptly.

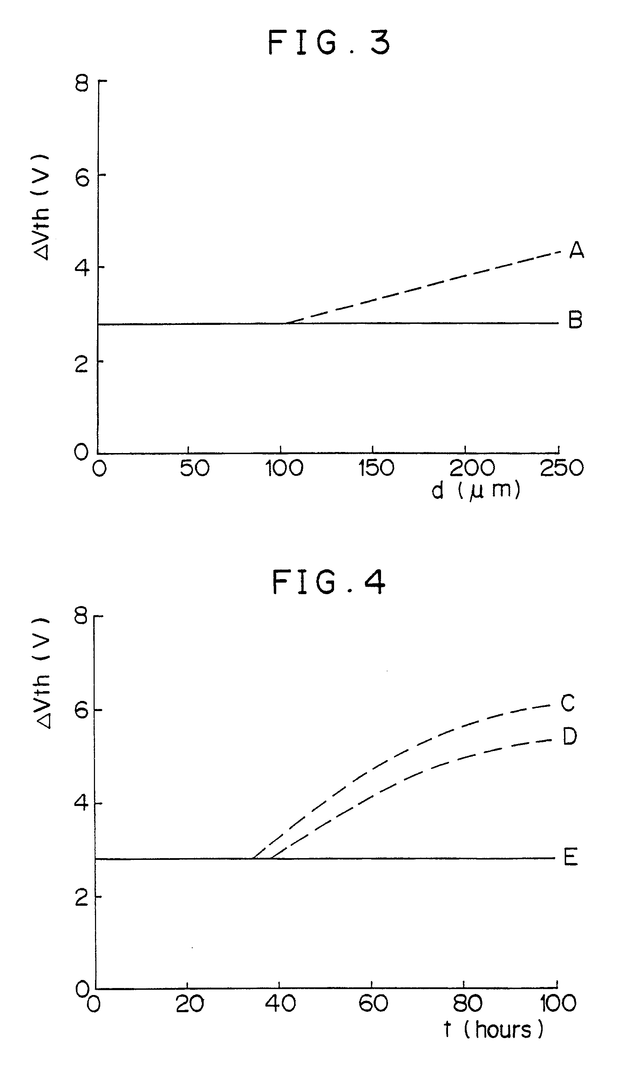

Figure 3 shows the practical effect of providing the window 8 for diffusing hydrogen to the outside. Figure 3 shows the change of threshold voltage $\Delta$Vth measured before and after a determined quantity of gate current flows in the MOS transistor by hot electron channel injection (i.e. the threshold voltage after the gate current injection minus the threshold voltage before the gate current injection) as a function of the distance d between the edge of the window 8 and the edge of the gate electrode 9.

The dotted line A demonstrates the characteristics of the MOS transistor using the double passivation layer comprising the PSG layer 5 and the P-SiN layer 7 which has the window 8. When the distance d is longer than 100 $\mu$m, the hydrogen does not sufficiently dissipate towards the outside, and so the change of threshold voltage caused by the hot electrons becomes larger. The line B shows a change of the threshold voltage value when only the single PSG layer 5 is used as the passivation layer for reference. Figure 3 teaches that if the edge of the window 8 in the P-SiN layer 7 is positioned within about 100 $\mu$m from the edge of the gate oxide layer, the window 8 is effective to diffuse the hydrogen out sufficiently.

Next, the wetproofing advantages of the semi-conductor device according to the present invention are described below. Figure 4 shows the change of threshold voltage $\Delta$Vth as a function of exposure time t when a fixed quantity of hot electrons is injected into the gate after exposing selected MOS transistors with different values for the distance d in a water vapour atmosphere at a high temperature and pressure.

The hot electrons deteriorate the transistor greatly in the instances when the distance d is 0

$\mu$m (dotted line C) or 10 $\mu$m (dotted line D) and the transistor is exposed in a water vapour atmosphere with a high temperature and pressure for around forty hours. This is due to the penetration of moisture through the window.

On the contrary, however, the transistor shows no increase in deterioration and sufficient wetproofing when the distance $\underline{d}$ is 20 $\mu$m to 100 $\mu$m (line E).

As described above, the present invention is advantageously capable of diffusing hydrogen out promptly and providing sufficient wetproofing as a result of the window 8 being provided at a distance of 20 $\mu$m to 100 $\mu$m away from the edge of the gate electrode.

**Claims**

1. A semi-conductor device having as a passivation layer, which covers a metal wire (4) of a MOS transistor and a semi-conductor surface, a double layer comprising a silicon nitride layer (7) and a silicide glass layer (5) beneath the silicon nitride layer, characterised in that a window (8) is provided through the silicon nitride layer at a location away from a gate electrode (9) of said MOS transistor.

2. A semi-conductor device as claimed in claim 1, characterised in that said window is provided at a location more than 20 $\mu$m away from an edge of said gate electrode.

3. A semi-conductor device as claimed in claim 1 or 2, characterised in that said window is provided at a location less than 100 $\mu$m away from an edge of said gate electrode.

4. A semi-conductor device having a double layer as a passivation layer, which covers a metal wire (4) of a MOS transistor and a semi-conductor surface comprising a silicon nitride layer (7) formed by a plasma CVD method and a silicide glass layer (5) beneath the silicon nitride, characterised in that a window (8) is provided through the silicon nitride layer at the portion away from a gate electrode (9) of said MOS transistor.

5. A passivation layer for a MOS transistor comprising a silicide glass layer (5) and a silicon nitride layer (7) on the silicide glass layer, characterised by said silicon nitride layer having a through hole (8) at a location adjacent to the MOS transistor.

# FIG.1

# FIG.2a

22    23

21

# FIG.2b

24

21

# FIG. 2c

25    24    26

21

# FIG. 2d

27

28    23

# FIG. 2e

29

# FIG. 2f

30    31

# FIG. 2g

33    32    31

34

# FIG.3

# FIG.4

# FIG.5